(19) Europäisches Patentamt / European Patent Office / Office européen des brevets

(11) **EP 3 751 262 A1**

(12) **EUROPEAN PATENT APPLICATION**
published in accordance with Art. 153(4) EPC

(43) Date of publication:
**16.12.2020 Bulletin 2020/51**

(21) Application number: **18904805.1**

(22) Date of filing: **02.11.2018**

(51) Int Cl.:
***G01N 25/20*** *(2006.01)*

(86) International application number:
**PCT/CN2018/113561**

(87) International publication number:
**WO 2019/153806 (15.08.2019 Gazette 2019/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.02.2018 CN 201810122868**

(71) Applicant: **Tsinghua University**
**Haidian District**
**Beijing 100084 (CN)**

(72) Inventors:
• **REN, Dongsheng**
**Beijing 100084 (CN)**

• **LIU, Xiang**
**Beijing 100084 (CN)**
• **FENG, Xuning**
**Beijing 100084 (CN)**
• **LU, Languang**
**Beijing 100084 (CN)**
• **OUYANG, Minggao**
**Beijing 100084 (CN)**
• **LI, Jianqiu**
**Beijing 100084 (CN)**

(74) Representative: **Balder IP Law, S.L.**
**Paseo de la Castellana 93**
**5ª planta**
**28046 Madrid (ES)**

(54) **THERMAL RUNAWAY PREDICTION METHOD AND DEVICE FOR POWER BATTERY SAFETY, AND COMPUTER READABLE STORAGE MEDIUM**

(57) A thermal runaway prediction method and device (11) for power battery safety, and a computer readable storage medium are provided. The method includes obtaining an initial temperature of a first power battery, calculating a temperature of the first power battery subjected to a thermal shock with a duration, and determining, on a basis of a thermal runaway model of the power battery, whether the first power battery will undergo a thermal runaway.

```
┌─────────────────────────────────────────┐        S10
│ Obtain an initial temperature of the first power battery │
└─────────────────────────────────────────┘
                     │
                     ▼                              S20
┌─────────────────────────────────────────┐
│ Compare the temperature of the first power battery │
│ subjected to the thermal shock with the duration with a │
│ thermal runaway standard value to determine whether the │
│ first power battery will undergo a thermal runaway │
└─────────────────────────────────────────┘
                     │
                     ▼                              S30
┌─────────────────────────────────────────┐
│ Determine a duration of a thermal shock applied to the first │
│ power battery, and calculate a temperature of the first │
│ power battery subjected to the thermal shock with the │
│ duration according to a thermal runaway model of the │
│ power battery and the initial temperature │
└─────────────────────────────────────────┘
```

FIG.1

EP 3 751 262 A1

**Description**

**CROSS-REFERENCE TO RELATED APPLICATIONS**

This application claims the priority of Chinese Patent Application No. 201810122868.7, filed on February 7, 2018, and entitled "Thermal Runaway Prediction Method and Device for Power Battery Safety, and Computer Readable Storage Medium", the disclosure of which is incorporated herein by reference in its entirety.

**TECHNICAL FIELD**

The present application relates to the technical field of battery, and more particularly, to a thermal runaway prediction method and device for power battery safety, and a computer readable storage medium.

**BACKGOUND**

Electric vehicles constitute the majority of new energy vehicles, while power batteries are the core energy sources of the electric vehicles. Nowadays, the lithium-ion power battery (hereinafter referred to as "power battery") is the most widely used chemical power source for vehicles and has the advantages of high energy density or power density and long service life. Due to the limited space in a vehicle, in addition to installing more power batteries in the limited space, it is more necessary to increase the specific energy of the power battery in order to increase a cruising range of the electric vehicle. To increase the specific energy of the power battery, various new material systems have been developed by applying exemplary technologies. However, when used in large-scaled industrial manufactures of batteries, these material systems are required to satisfy a series of industry standards including service life standards and safety standards. Since the energy released during the thermal runaway is more concentrated when the power battery with relatively high specific energy encounters a safety incident, the safety performance of the mass-produced batteries during the thermal runaway must be guaranteed at the design and development stages of the power battery with the relatively high specific energy.

Generally, when evaluating the safety performance of a new type of battery material during a thermal runaway event, only if battery designers produce a certain number of (e.g., dozens of) batteries containing the material, and then perform a series of safety tests for the batteries, can they evaluate the safety performance of the battery material during the thermal runaway. In this exemplary experiment based method for evaluating the safety performance of the battery during the thermal runaway, the power batteries have to be assembled and subjected to a large number of safety tests, which will consume about a few kilograms of electrode materials. Moreover, a lot of manpower and material resources will be invested in the preparation and safety tests of the batteries, which is unfavorable to the improvement of the efficiency of the battery design and development.

**SUMMARY**

Based on this, it is necessary to provide a thermal runaway prediction method and device for power battery safety, and a computer readable storage medium, to address the problems that the conventional method for evaluating thermal runaway of the power battery consumes a great deal of materials and has low efficiency of battery development.

A thermal runaway prediction method for power battery safety includes:

S10, obtaining an initial temperature of the first power battery;

S20, determining a duration of a thermal shock applied to the first power battery, and calculating a temperature of the first power battery subjected to the thermal shock with the duration according to a thermal runaway model of the power battery and the initial temperature; and

S30, comparing the temperature of the first power battery subjected to the thermal shock with the duration with a thermal runaway standard value to determine whether the first power battery will undergo a thermal runaway.

According to the thermal runaway prediction method for power battery safety provided by the embodiment of the present application, firstly, the initial temperature of the first power battery is obtained. Secondly, the duration of the thermal shock applied to the first power battery is determined. Based on the thermal runaway model of the power battery and the initial temperature of the first power battery, the temperature of the first power battery subjected to the thermal shock with the duration is calculated. Finally, the temperature of the first power battery subjected to the thermal shock with the duration is compared with the thermal runaway standard value, so as to determine whether the first power battery will undergo the thermally runaway. Predicting the thermal runaway of the first dynamic battery based on the thermal runaway model of the power battery can reduce the waste of battery materials, save costs, and can also help to improve the efficiency of designing and developing the battery.

## DESCRIPTION OF THE DRAWINGS

In order to describe the embodiments of the present application or the technical solutions in the prior art more clearly, the figures to be used in describing the embodiments or the prior art will be briefly described. Obviously, the figures to be described below are merely embodiments of the present application. For those skilled in the art, other figures may be obtained according to these figures without any creative work.

FIG. 1 is a flow chart of a thermal runaway prediction method for power battery safety according to an embodiment of the present application;
FIG. 2 is a diagram illustrating curves of scanning calorimetry measurements of test samples at a single temperature rising rate according to an embodiment of the present application;
FIG. 3 is a diagram illustrating curves of scanning calorimetry measurements of a test sample consisting of anode and cathode materials at multiple temperature rising rates according to an embodiment of the present application;
FIG. 4 is a diagram illustrating comparisons between calculated results and experimental results of scanning calorimetry measurements for the test sample consisting of anode and cathode materials at multiple temperature rising rates according to an embodiment of the present application;
FIG. 5 is a diagram illustrating a comparison between a result of the thermal runaway prediction model and an actual experimental result according to an embodiment of the present application;
FIG. 6 is a diagram illustrating a comparison between a result of the thermal runaway prediction model and an actual experimental result according to an embodiment of the present application;
FIG. 7 is a structural diagram illustrating a thermal runaway prediction device for power battery safety according to an embodiment of the present application.

## DETAILED DESCRIPTION OF EMBODIMENTS

The technical solutions in the embodiments of the present application will be clearly and completely described below with reference to the drawings in the embodiments of the present application. Obviously, the described embodiments are only a part of the embodiments of the present application, rather than all the embodiments. Based on the embodiments of the application, all other embodiments obtained by those skilled in the art without creative work will fall in the protection scope of the present application.

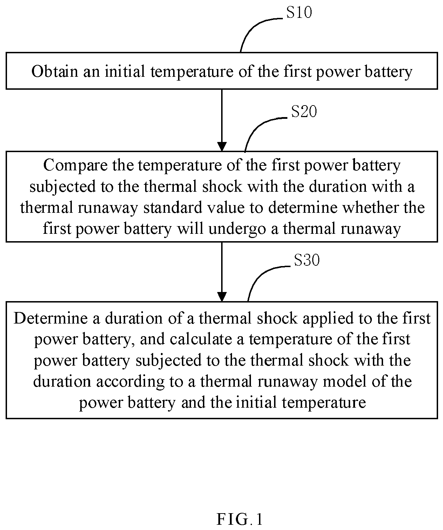

Referring to FIG. 1, an embodiment of the present application provides a thermal runaway prediction method for power battery safety. The thermal runaway prediction method for power battery safety includes steps:

S10, obtaining an initial temperature of a first power battery;
S20, determining a duration of a thermal shock applied to the first power battery, and calculating a temperature of the first power battery subjected to the thermal shock with the duration according to a thermal runaway model of the power battery and the initial temperature; and
S30, comparing the temperature of the first power battery subjected to the thermal shock with the duration with a thermal runaway standard value, to determine whether the first power battery will undergo a thermal runaway.

In this embodiment, in S10, the initial temperature of the first power battery can be a starting temperature of the first power battery before it is subjected to the thermal shock.

In S20, the duration of the thermal shock applied to the first power battery is the duration in which the first power battery is subjected to a certain thermal shock condition. The thermal shock can be an influence of a high-temperature environment on the first power battery. The temperature of the first power battery subjected to the thermal shock with the duration can be calculated on the basis of the thermal runaway model of the power battery.

In S30, it can be determined whether the first power battery will undergo a thermal runaway according to the standard value. The standard value can be set according to an experience value. The standard value can be a critical value for determining whether the first power battery will undergo the thermal runaway. When the temperature of the first power battery subjected to the thermal shock with the duration is less than the standard value, it can be judged that the thermal runaway of the first power battery will not occur under such a thermal shock condition. When the temperature of the first power battery subjected to the thermal shock with the duration is greater than the standard value, it can be judged that a thermal runaway of the first power battery will easily occur under such a thermal shock condition.

In an embodiment, the standard value can include three standard sub-values of "high", "medium", and "low". The three standard sub-values of "high", "medium" and "low" can represent the magnitudes of the temperature values. The temperature values corresponding to the three standard sub-values of "high", "medium" and "low" can decrease sequentially. The three standard sub-values can divide a risk of thermal runaway of the first power battery into four levels:

when the temperature of the first power battery is higher than the "high" standard sub-value, the risk of thermal runaway of the first power battery is the highest;
when the temperature of the first power battery is between the "high" standard sub-value and the "medium" standard sub-value, the risk of thermal runaway of the first power battery is relatively high;
when the temperature of the first power battery is between the "medium" standard sub-value and the "low" standard sub-value, the risk of thermal runaway of the first power battery is relatively low; and
when the temperature of the first power battery is less than the "low" standard sub-value, the risk of thermal runaway of the first power battery is the lowest.

According to the thermal runaway prediction method for the power battery safety provided by the embodiment of the present application, firstly, the initial temperature of the first power battery is obtained. Secondly, the duration of the thermal shock applied to the first power battery is determined. Based on the thermal runaway model of the power battery and the initial temperature of the battery, the temperature of the first power battery subjected to the thermal shock with the duration is calculated. Finally, the temperature of the first power battery subjected to the thermal shock with the duration is compared with a thermal runaway standard value, so as to determine whether the first power battery will undergo the thermal runaway. Predicting the thermal runaway of the first dynamic battery based on the thermal runaway model of the power battery can reduce the waste of battery materials, save costs, and can also help to improve the efficiency of designing and developing the battery.

In an embodiment, the method for establishing the thermal runaway model of the power battery includes:

S210, preparing a second power battery;
S220, disassembling the second power battery which is at a fully charged state, and obtaining anode and cathode materials of the second power battery to prepare a test sample;
S230, performing a scanning calorimetry measurement on the test sample to obtain experimental temperature data of the test sample and experimental heat generation power data of the test sample;
S240, calculating kinetic parameters of a reaction of the test sample based on the experimental temperature data of the test sample and the experimental heat generation power data of the test sample;
S250, establishing the thermal runaway model of the power battery based on a kinetic equation of the reaction, a principle of mass conservation, an energy conservation equation, and the kinetic parameters.

In this embodiment, in S210, the second power battery can be a half cell produced by using the materials for preparing the first power battery, or be a model battery of the first power battery. Therefore, the thermal runaway model of the power battery established on the basis of the second power battery can predict the thermal runaway of the first power battery. During preparation of the second power battery, the requirements of the anode active material, the cathode active material, the binder, the conducting agent, the electrolyte, and the separator can be determined according to the capacity and energy requirements, and the proportions of the various materials are also determined accordingly. During preparation of the anode plate and the cathode plate, the electrode active material, the conducting agent and the binder are mixed according to a set ratio and formed into a slurry Then, the slurries are evenly coated on the current collectors, which are then compressed, cut, and dried to finally obtain the anode plate and the cathode plate.

In an embodiment, the cathode active material of the power battery is a ternary cathode active material ($Li_xNi_{1/3}Co_{1/3}Mn_{1/3}O_2$); the anode active material is graphite; the conducting agent is acetylene black; the binder is polyvinylidene fluoride (PVDF); the cathode current collector is an aluminum foil; and the anode current collector is a copper foil. As for the cathode of the second power battery, the proportion of the ternary cathode active material to the conducting agent to the binder is 95:3:2. As for the anode of the second power battery, the proportion of the anode active material to the conducting agent to the binder is 85:5:10. In an embodiment, the separator used in the first power battery is a polyethylene (PE) separator having one surface coated with a ceramic layer, and the electrolyte consists of lithium salt $LiPF_6$ and an organic solvent. The second power battery is assembled by having the cathode plate as the cathode, having the anode plate as the anode, adding an appropriate amount of electrolyte, and interposing the separator. In an embodiment, the second power battery can be a lithium-ion power battery with a small capacity, a button cell, a small-sized soft pack battery, or a small square-shaped battery. In an embodiment, the capacity of the small-sized power battery is less than 100 mAh. After the second power battery is prepared, formation process is performed on it, so that a stable interface protective film is formed on the surfaces of the cathode plate and the anode plate of the second power battery.

In an embodiment, the step S220 includes:

S310, disassembling the second power battery which is at the fully charged state in a glove box filled with argon gas to obtain an anode plate and a cathode plate which are at the fully charged state;
S320, scraping the anode plate and the cathode plate off from the current collectors, and grinding the anode plate and the cathode plate to obtain the anode material and the cathode material.

In an embodiment, before step S320, the method further includes:
S311, immersing the obtained anode plate and cathode plate respectively in dimethyl carbonate solution.

In S220, a charging-discharging test is performed on the prepared second power battery, and a state of charge of the second power battery is regulated to a fully charged state. In an embodiment, the second power battery is charged to 4.2V at a low constant current and then at a constant voltage to regulate the state of charge of the second power battery to a fully charged state. In an embodiment, the fully charged second power battery can be disassembled inside the glove box filled with argon gas, so as to obtain the anode plate and cathode plate at the fully charged state. Before preparing the test sample for the calorimetry measurement, the anode plate and the cathode plate can be respectively immersed in the dimethyl carbonate solution for a time period of the duration(usually half an hour). The residual lithium salt on the electrode plates can be washed away, and then the electrode plates are dried. The whole process can be carried out inside the glove box. Subsequently, the anode plate and the cathode plate are scraped off from the current collectors, and then are lightly ground to obtain anode plate powder and cathode plate powder. The anode plate powder and the cathode plate powder can be used as the anode material and the cathode material, respectively.

In an embodiment, the second power battery includes a second electrolyte. The second electrolyte can be any electrolyte suitable for the second power battery. The test samples are the first sample consisting of the second electrolyte, the anode material and the cathode material, the second sample consisting of the second electrolyte and the cathode material, the third sample consisting of the anode material and the second electrolyte, and the fourth sample consisting of the anode material and the cathode material. According the thermal decomposition reaction that may occur inside the first power battery, the first sample, the second sample, the third sample, and the fourth sample can be obtained by mixing the anode material, the cathode material, and the electrolyte respectively in accordance with a mass proportion thereof which is set during the design of the first power battery. In an embodiment, the compositions of the four samples are as follows:

the first sample consists of: the cathode material (6mg), the anode material (3.4mg), and the electrolyte (3mg);
the second sample consists of: the cathode material (6mg) and the electrolyte (3mg);
the third sample consists of: the anode material (3.4mg) and the electrolyte (3mg);
the fourth sample consists of: the cathode material (6mg) and the anode material (3.4mg).

In an embodiment, the S230 includes:

S231, selecting a temperature rising rate, and respectively performing scanning calorimetry measurements on the first sample, the second sample, the third sample, and the fourth sample at the temperature rising rate, to obtain first experimental temperature data and first experimental heat generation power data corresponding to the sample experimental temperature data;
S232, screening a dominant exothermic reaction sample from the first sample, the second sample, the third sample, and the fourth sample based on the first experimental temperature data and the first experimental heat generation power data;
S233, selecting multiple temperature rising rates, and performing multiple scanning calorimetry measurements on the dominant exothermic reaction sample at the multiple temperature rising rates respectively, to obtain multiple sets of second experimental temperature data and multiple sets of second experimental heat generation power data corresponding to the multiple sets of second experimental temperature data in a one-to-one manner.

In S231, the obtained first sample, second sample, third sample, and fourth sample can be placed into the sample making crucibles of a differential scanning calorimeter and sealed. In an embodiment, material samples, such as the separator and the electrolyte used for preparing the first power battery, can be placed in the sample making crucibles of the differential scanning calorimeter via the glove box and sealed.

In an embodiment, a temperature rising rate is selected via the differential scanning calorimeter, and the scanning calorimetry measurements are performed on the first sample, the second sample, the third sample, and the fourth sample. The selected temperature rising rate can be any one of 0.5°C/min, 1°C/min, 2°C/min, 5°C/min, 10°C/min, 15°C/min, and 20°C/min. For a sample y, the obtained result of the scanning calorimetry measurement includes a set of first experimental temperature data $T_y$, the first experimental heat generation power data $Q_y$ of the test sample, which correspond to the first experimental temperature data $T_y$, and the measurement time $t_y$.

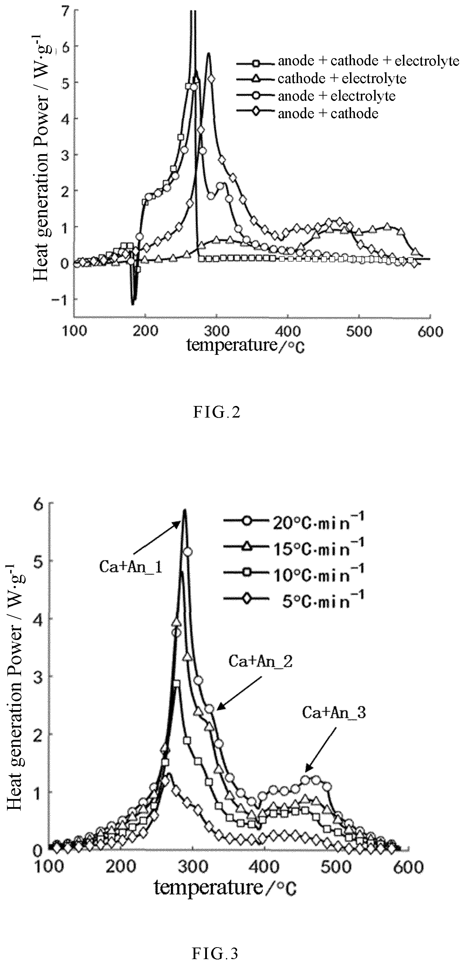

In S232, by comparing the results of the scanning calorimetry measurements of the four samples, the dominant exothermic reaction sample during the thermal runaway of the battery can be determined. In an embodiment, FIG. 2 shows the obtained results of the scanning calorimetry measurements of the four samples. In FIG. 2, a unit of the heat generation power data $Q_y$ is W·g$^{-1}$. The unit W·g$^{-1}$ can be obtained by dividing the generated heat by a sum (i.e. 12.4 mg) of masses of the anode material, the cathode material, and the electrolyte. It can be seen from FIG.2 that the first sample generates a large amount of heat at a temperature of about 260°C. The instantaneous heat generation power is extremely high and exceeds the measurement range of the instrument. By comparing the results of the scanning calorimetry measurements of the other three samples, it can be found that the initial heat generation of the battery mainly comes from the third sample consisting of the cathode material and the electrolyte. It can also be found that the second sample consisting of the cathode material and the anode material also begins to release heat when the temperature is higher than 200°C. However, the second sample consisting of the second electrolyte and the cathode material releases very little heat. Accordingly, it can be determined that the dominant exothermic reactions inside the battery are caused by the third sample consisting of the anode material and the electrolyte, and the fourth sample consisting of the anode material and the cathode material. That is, the dominant exothermic reaction samples are the third sample and the fourth sample.

In S233, the differential scanning calorimeter can perform multiple scanning calorimetry measurements on the dominant exothermic reaction sample at different temperature rising rates respectively. In an embodiment, at least four scanning calorimetry measurements at four different temperature rising rates can be performed. The selected temperature rising rates for the scanning can be four of 0.5°C/min, 1°C/min, 2°C/min, 5°C/min, 10°C/min, 15°C/min and 20°C/min. That is, four scanning calorimetry measurements at four different temperature rising rates can be performed on each dominant exothermic reaction sample. In an embodiment, multiple scanning calorimetry measurements at multiple temperature rising rates can be performed by the differential scanning calorimeter on the separator used in the second power battery. In an embodiment, four scanning calorimetry measurements at four temperature rising rates can be performed respectively on the third sample and the fourth sample respectively. The selected temperature rising rates can be 5°C/min, 10°C/min, 15°C/min, and 20°C/min. Through the four scanning calorimetry measurements at the four temperature rising rates, four sets of second experimental temperature data can be obtained for each of the third sample and the fourth sample, and four sets of second experimental heat generation data corresponding to the four sets of second experimental temperature data in a one-to-one manner can be obtained as well for each of the third sample and the fourth sample.

In an embodiment, the S240 includes:

S241, obtaining multiple temperature-power curves based on the multiple sets of the second experimental temperature data and the multiple sets of the second experimental heat generation power data corresponding to the multiple sets of the second experimental temperature data in the one-to-one manner;

S242, obtaining the number of exothermic reactions of each dominant exothermic reaction sample based on the temperature-power curves;

S243, calculating the kinetic parameters of the each dominant exothermic reaction sample by a numerical optimization method based on the mass conservation equation, the heat generation power calculation formula, the total heat generation power calculation formula, the kinetic equation, the temperature-power curves, and the number of the exothermic reactions of the each dominant exothermic reaction sample.

In S242, in an embodiment, the scanning calorimetry measurements can be performed on the sample $y$. According to the temperature-power curves, it can be known that the sample $y$ can have multiple exothermic reactions $x$. The subscripts of the exothermic reactions $x$ can be denoted by $x=y\_1$, $x=y\_2$, $x=y\_3$, etc, respectively.

In an embodiment, the dominant exothermic reactions $x$ of the sample consisting of the anode material and the electrolyte and the sample consisting of the anode material and the cathode material under high temperature conditions, and the corresponding signs are listed in Table 1:

Table 1 Dominant exothermic reactions $x$ and corresponding signs thereof in the embodiments of the present application

| Reaction System $y$ | Sign of $y$ | Exothermic Reaction $x$ | Sign of Reaction $x$ |
|---|---|---|---|
| Anode and Electrolyte | An+Ele | Decomposition Reaction of Solid Electrolyte Interface Film | An+Ele_1 |
| | | Reaction between Anode and Electrolyte | An+Ele _2 |
| | | Reaction between Anode and Binder | An+Ele_3 |

(continued)

| Reaction System y | Sign of y | Exothermic Reaction x | Sign of Reaction x |
|---|---|---|---|
| Anode and Cathode | Ca+An | Reaction between Anode and Cathode | Ca+An_1 |
| | | Reaction between Cathode and Binder | Ca+An 2 |
| | | Decomposition Reaction of Cathode | Ca+An_3 |
| Separator | Sep | Melting of Separator | Sep |

In an embodiment, a kinetic equation is established for each of the dominant exothermic reactions x as follows:

$$\frac{dc_x}{dt} = A_x \cdot \exp(-\frac{E_{a,x}}{R \cdot T}) \cdot c_x^{n_x} \qquad (1).$$

Where x denotes the exothermic reaction of the test sample; $c_x$ denotes a normalized concentration of the reactant of the exothermic reaction, and has a unit of 1; $A_x$ denotes a forward factor of the exothermic reaction, and has a unit of $s^{-1}$; $E_{a,x}$ denotes activation energy of the exothermic reaction, and has a unit of $J \cdot mol^{-1}$; $R$ denotes the ideal gas constant which is 8.314 $J \cdot mol^{-1} \cdot K^{-1}$; $n_x$ denotes an order of the exothermic reaction, and has a unit of 1; and $A_x$, $E_{a,x}$ and $n_x$ are the kinetic parameters of the exothermic reaction x.

In an embodiment, during the exothermic reaction, the concentration of the reactant of the exothermic reaction follows the mass conservation equation:

$$c_x = 1 - \int \frac{dc_x}{dt} dt \qquad (2).$$

In an embodiment, correspondingly, the heat generation power calculation formula of the exothermic reaction x is:

$$Q_x = m \cdot H_x \cdot \frac{dc_x}{dt} \qquad (3).$$

Where $Q_x$ denotes the heat generation power of the exothermic reaction x; m denotes a sum of the masses of the anode, the cathode, and the electrolyte, and has a unit of g; and $H_x$ is reaction enthalpy of the exothermic reaction x, and has a unit of $J \cdot g^{-1}$.

The total heat generation power of sample y is a sum of the heat generation powers of all dominant exothermic reactions. The calculation formula is:

$$Q_y = Q_{y\_1} + Q_{y\_2} + Q_{y\_3} + \cdots \qquad (4)$$

In the formula, y denotes the dominant exothermic reaction sample, and y_1, y_2, and y_3 denote the exothermic reactions of the dominant exothermic reaction sample.

According to the results of the scanning calorimetry measurements at the multiple temperature rising rates, a set of kinetic parameters of the exothermic reaction x of the dominant exothermic reaction sample is given by [$A_x$, $E_{a,x}$, $n_x$, $H_x$], and the temperature-power curves between the experimental heat generation power data $Q_y$ and the experimental temperature data $T_y$ of the dominant exothermic reaction sample at different temperature rising rates can be established through calculation. An error between the calculated temperature-power curve and the experimental curve obtained by the scanning calorimetry measurement is computed to be minimal by coupling equations (1) to (4) and by using the numerical optimization method, thus obtaining the kinetic parameters [$A_x$, $E_{a,x}$, $n_x$, $H_x$] of each exothermic reaction x of the dominant exothermic reaction sample.

In an embodiment, the numerical optimization method can be a particle swarm optimization method, a genetic algorithm, or a least squares method.

In an embodiment, when the dominant exothermic reaction sample y is the fourth sample consisting of the anode material and the cathode material (i.e., y=Ca+An), four scanning calorimetry measurements are performed at four different temperature rising rates on the fourth sample. The four temperature rising rates can be {5°C/min, 10°C/min, 15°C/min, 20°C/min}. FIG.3 shows the scanning calorimetry measurement results of the fourth sample at the four different temperature rising rates.

The exothermic reactions of the fourth sample are denoted by Ca+An_1, Ca+An_2, and Ca+An_3, respectively. The error between each of the calculated temperature-power curves and the corresponding experimental curve of the scanning calorimetry measurement is computed to be the minimum by coupling the equations (1) to (4) and by using the least square method, thus obtaining the kinetic parameters $[A_x, E_{a,x}, n_x, H_x]$ of each of the exothermic reactions $x$ of the dominant exothermic reaction sample.

Table 2 Reaction Kinetic Parameters and Reaction Enthalpy of each dominant reaction of the embodiments of the present application

| Sign of Reaction $x$ | Reaction Kinetic Parameter | | | Reaction Enthalpy |
|---|---|---|---|---|
| | $A_x$ [s$^{-1}$] | $E_{a,x}$ [J·mol$^{-1}$] | $n_x$ [1] | $H_x$ [J·g$^{-1}$] |
| An+Ele_1 | $6.3623 \times 10^9$ | $1.0960 \times 10^5$ | 5.5 | 578.7 |
| An+Ele_2 | $5.1510 \times 10^{17}$ | $2.0077 \times 10^5$ | 1 | 253.2 |
| An+Ele_3 | $4.9679 \times 10^{15}$ | $1.9549 \times 10^5$ | 1 | 108.5 |
| Ca+An_1 | $2.4262 \times 10^{13}$ | $1.6201 \times 10^5$ | 1 | 578.7 |
| Ca+An_2 | $6.5429 \times 10^{13}$ | $1.7785 \times 10^5$ | 2 | 434.0 |
| Ca+An_3 | $5.3481 \times 10^5$ | $1.0934 \times 10^5$ | 1.5 | 434.0 |
| Sep | $6.74 \times 10^{44}$ | $3.69 \times 10^5$ | 1 | -15 |

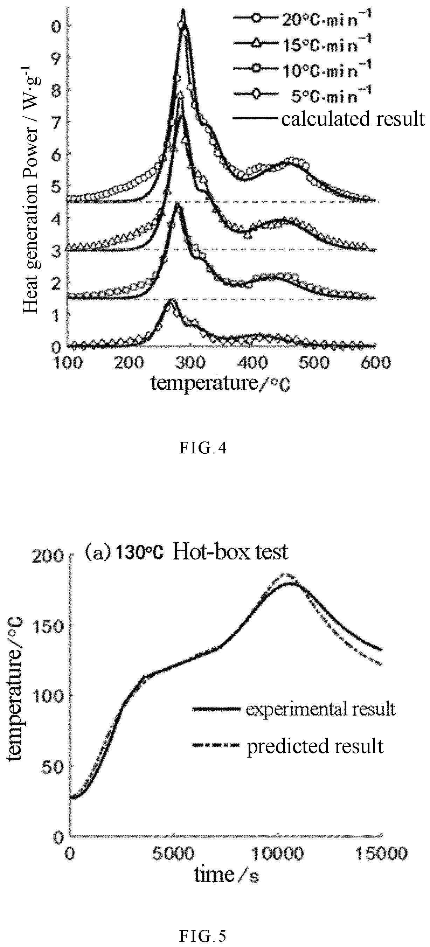

FIG. 4 shows the calculated results obtained by substituting the above optimal parameters into the equations (1) to (4). As shown in FIG.4, the calculated results are very approximate to the experimental results, which indicates that the calculated kinetic parameters are relatively reasonable.

Based on the mass conservation equation of the reactants, the relationship between the dominant reactions during the thermal runaway of the second power battery is established.

In an embodiment, according to the energy conservation equation, the temperature rising rate $\dfrac{\mathrm{d}T}{\mathrm{d}t}$ of the power battery satisfies:

$$\frac{\mathrm{d}T}{\mathrm{d}t} = \frac{Q + h \cdot A \cdot (T_A - T)}{M \cdot C_p} \qquad (5)$$

Where, h denotes a convective heat transfer coefficient between the battery and the environment; $A$ denotes a heat exchange area; $T_A$ denotes an ambient temperature; $M$ denotes a mass of the second power battery; and Q denotes a sum of the heat generated by each dominant reaction, satisfying an equation:

$$Q = \sum_x Q_x \qquad (6)$$

$Q_x$ can be computed by coupling equations (1) to (3).

Then, a thermal runaway prediction model can be established for the power battery safety as follows:

$$T1 = \int_t \frac{\mathrm{d}T}{\mathrm{d}t} \mathrm{d}t + T_0 \qquad (7)$$

To denotes the initial temperature of the battery, and $T1$ denotes the temperature of the first power battery subjected to the thermal shock with the duration.

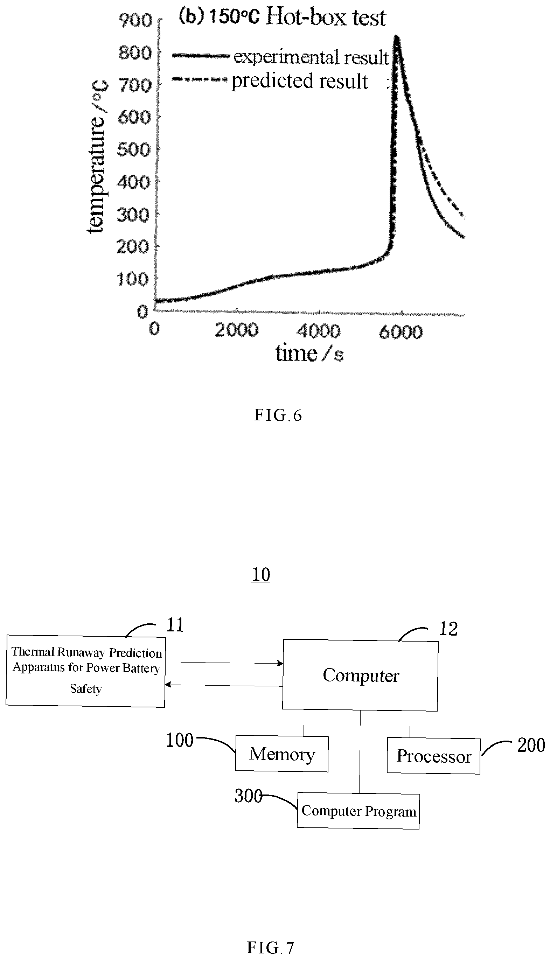

Based on the thermal runaway prediction model for the power battery safety, the performances of the thermal runaway of the first power battery under different thermal shocks can be predicted. FIG. 5 illustrates a comparison between the predicted result and the experimental result of the first power battery in a hot box with a temperature of 130°C according to an embodiment of the present application. It can be seen that the result obtained by the thermal runaway prediction method for the power battery safety and the experimental result fit well. The first power battery can safely pass the hot box test with the temperature of 130°C, and no thermal runaway occurs. FIG. 6 illustrates a comparison between the predicted result and the experimental result of the first power battery in the hot box with a temperature of 150°C according to an embodiment of the present application. It can be seen that the result obtained by the thermal runaway prediction method for the power battery safety and the experimental result fit well. The first power battery cannot pass the hot box test with the temperature of 150°C, and the thermal runaway occurs.

As can be seen from FIG. 5 and FIG. 6, the thermal runaway prediction method for the power battery safety of the present application can accurately predict the temperature responses of the first power battery under different thermal shocks, and the prediction precision is high. The thermal runaway prediction method for the power battery safety of the present application can accurately predict the safety performances of the thermal runaway of the battery based on the scanning calorimetry measurement of a small amount of materials, and can be used to guide the safety design and material selection of the battery.

Referring to FIG. 7, an embodiment of the present application also provides a thermal runaway prediction device 10 for power battery safety. The thermal runaway prediction device 10 for the power battery safety includes the thermal runaway prediction apparatus 11 for the power battery safety and a computer 12. The computer 12 includes a memory 100, a processor 200, and computer programs 300 stored on the memory 200 and executed by the processor 200. When the processor 200 executes the computer programs 300, the thermal runaway prediction method for the power battery safety is performed, and the method includes:

S10, obtaining an initial temperature of the first power battery;

S20, determining a duration of a thermal shock applied to the first power battery, and calculating a temperature of the first power battery subjected to the thermal shock with the duration according to a thermal runaway model of the power battery and the initial temperature; and

S30, comparing the temperature of the first power battery subjected to the thermal shock with the duration with a thermal runaway standard value to determine whether the first power battery will undergo a thermal runaway.

In an embodiment of the present application, a computer readable storage medium is provided, on which computer programs are stored. By executing the computer programs, the processer is capable of performing the above-described method.

It should be understood by the ordinary skilled in the art that, all or part of the processes in the methods of the above embodiments can be implemented through computer programs controlling corresponding hardware; the computer programs can be stored in the computer readable storage medium; and when the computer programs are executed, they can include the processes in the methods of the above embodiments. Wherein, any memory, storage, databases or other medium described in all embodiments provided by the present application can include non-volatile and/or volatile memory. Non-volatile memory can include Read-Only Memory (ROM), Programmable ROM (PROM), Erasable Programmable ROM (EPROM), Electrically Erasable Programmable ROM (EEPROM), or flash memory. Volatile memory can include Random Access memory (RAM) or external cache memory. Not illustrated as limitation but as explanations, RAM can be any one of Static RAM (SRAM), Dynamic RAM (DRAM), Synchronous DRAM (SDRAM), Double Data Rate SDRAM (DDR SDRAM), Enhanced SDRAM (ESDRAM), Synchronization Link DRAM (SLDRAM), Rambus Direct RAM (RDRAM), Direct Rambus Dynamic RAM (DRDRAM), and Rambus Dynamic RAM (RDRAM).

Finally, it should be noted that in the description, relational terms such as first and second are only used to distinguish one entity or operation from another entity or operation, but do not necessarily require or imply any such actual relationship or sequence between these entities or operations. Moreover, the terms "include", "comprise" or any other variants thereof are intended to cover non-exclusive inclusion, so that a process, method, article or device including a series of elements not only includes those elements, but also includes those that are not explicitly listed, or includes other elements inherent to the process, the method, the article or the equipment. If there are no more restrictions, the element defined by the sentence "including a..." does not exclude the existence of other same elements in the process, method, article, or equipment that includes the element.

The various embodiments of the present specification are described in a progressive manner, and each embodiment focuses on the differences from other embodiments, and the same or similar parts between the various embodiments can be referred to each other.

The above description of the disclosed embodiments enables those skilled in the art to implement or use this application. Various modifications for these embodiments are obvious for those skilled in the art will be to. The general principles defined in the present disclosure can be implemented in other embodiments without departing from the spirit or scope of the present application. Therefore, this application should not be limited to the embodiments described in the present disclosure, but should conform to the widest scope consistent with the principles and novel features of the present disclosure.

**Claims**

1. A thermal runaway prediction method for power battery safety, **characterized by** comprising:

S10, obtaining an initial temperature of the first power battery;
S20, determining a duration of a thermal shock applied to the first power battery, and calculating a temperature of the first power battery subjected to the thermal shock with the duration according to a thermal runaway model of the power battery and the initial temperature; and
S30, comparing the temperature of the first power battery subjected to the thermal shock with the duration with a thermal runaway standard value to determine whether the first power battery will undergo a thermal runaway.

2. The thermal runaway prediction method of claim 1, **characterized in that**, in the S20, a method for establishing the thermal runaway model of the power battery comprises:

S210, preparing a second power battery;
S220, disassembling the second power battery which is at a fully charged state, and obtaining anode material and cathode material to prepare a test sample;
S230, performing a scanning calorimetry measurement on the test sample to obtain experimental temperature data of the test sample and experimental heat generation power data of the test sample;
S240, calculating kinetic parameters of a reaction of the test sample based on the experimental temperature data of the test sample and the experimental heat generation power data of the test sample;
S250, establishing the thermal runaway model of the power battery based on a kinetic equation of the reaction, a principle of mass conservation, an energy conservation equation, and the kinetic parameters.

3. The thermal runaway prediction method of claim 2, **characterized in that**, the second power battery comprises a second electrolyte, and the test sample is a plurality of test samples which are:

a first sample consisting of the second electrolyte, an anode material, and a cathode material;
a second sample consisting of the second electrolyte and the cathode material;
a third sample consisting of the anode material and the second electrolyte; and
a fourth sample consisting of the anode material and the cathode material.

4. The thermal runaway prediction method of claim 3, **characterized in that**, the S230 comprises:

S231, selecting a temperature rising rate, and respectively performing scanning calorimetry measurements on the first sample, the second sample, the third sample, and the fourth sample at the temperature rising rate, to obtain first experimental temperature data and first experimental heat generation power data corresponding to the first experimental temperature data;
S232, screening a dominant exothermic reaction sample from the first sample, the second sample, the third sample, and the fourth sample based on the first experimental temperature data and the first experimental heat generation power data;
S233, selecting multiple temperature rising rates, and performing multiple scanning calorimetry measurements on the dominant exothermic reaction sample at the multiple temperature rising rates respectively, to obtain multiple sets of second experimental temperature data and multiple sets of second experimental heat generation power data corresponding to the multiple sets of second test sample experimental temperature data in a one-to-one manner.

5. The thermal runaway prediction method of claim 4, **characterized in that**, the S240 comprises:

S241, obtaining multiple temperature-power curves based on the multiple sets of the second experimental temperature data and the multiple sets of the second experimental heat generation power data corresponding to the multiple sets of the second experimental temperature data in the one-to-one manner;
S242, obtaining a number of exothermic reactions of each dominant exothermic reaction sample based on the temperature-power curves;

S243, calculating the kinetic parameters of the each dominant exothermic reaction sample by a numerical optimization on the basis of a mass conservation equation, a heat generation power calculation formula, a total heat generation power calculation formula, the kinetic equation, the temperature-power curves, and the number of the exothermic reactions of the each dominant exothermic reaction sample.

6. The thermal runaway prediction method of claim 5, **characterized in that**, the kinetic equation is

$$\frac{\mathrm{d}c_x}{\mathrm{d}t} = A_x \cdot \exp\left(-\frac{E_{a,x}}{R \cdot T}\right) \cdot c_x^{n_x} \tag{1}$$

wherein $x$ denotes the exothermic reaction of the test sample; $c_x$ denotes a normalized concentration of a reactant of the exothermic reaction, and has a unit of 1; $A_x$ denotes a forward factor of the exothermic reaction, and has a unit of $\mathrm{s}^{-1}$; $E_{a,x}$ denotes activation energy of the exothermic reaction, and has a unit of $\mathrm{J \cdot mol^{-1}}$; $R$ denotes an ideal gas constant which is 8.314 $\mathrm{J \cdot mol^{-1} \cdot K^{-1}}$; $n_x$ denotes an order of the exothermic reaction, and has a unit of 1; $A_x$, $E_{a,x}$ and $n_x$ are the kinetic parameters of the exothermic reaction $x$, and $T$ denotes a reaction temperature.

7. The thermal runaway prediction method of claim 6, **characterized in that**, the mass conservation equation is:

$$c_x = 1 - \int \frac{\mathrm{d}c_x}{\mathrm{d}t} \mathrm{d}t \tag{2}$$

wherein $c_x$ denotes the normalized concentration of the reactant of the exothermic reaction, and has the unit of 1.

8. The thermal runaway prediction method of claim 7, **characterized in that**, the heat generation power calculation formula of each exothermic reaction is:

$$Q_x = m \cdot H_x \cdot \frac{\mathrm{d}c_x}{\mathrm{d}t} \tag{3}$$

wherein $Q_x$ denotes the heat generation power of the exothermic reaction $x$; $m$ denotes a sum of masses of the anode, the cathode, and the electrolyte, and has a unit of g; and $H_x$ is reaction enthalpy of the exothermic reaction $x$, and has a unit of $\mathrm{J \cdot g^{-1}}$.

9. The thermal runaway prediction method of claim 8, **characterized in that**, the total heat generation power calculation formula is:

$$Q_y = Q_{y\_1} + Q_{y\_2} + Q_{y\_3} + \cdots \tag{4}$$

wherein y denotes the dominant exothermic reaction sample, and y_1, y_2, and y_3 denote the exothermic reactions of the dominant exothermic reaction sample.

10. The thermal runaway prediction method of claim 9, **characterized in that**, according to the energy conservation equation, the temperature rising rate $\frac{\mathrm{d}T}{\mathrm{d}t}$ of the power battery satisfies:

$$\frac{\mathrm{d}T}{\mathrm{d}t} = \frac{Q + h \cdot A \cdot (T_A - T)}{M \cdot C_p} \tag{5}$$

wherein $h$ denotes a convective heat transfer coefficient between the battery and an environment; $A$ denotes a heat exchange area; $T_A$ denotes an ambient temperature; $M$ denotes a mass of the second power battery; and Q denotes a sum of heat generated by each dominant exothermic reaction, satisfying an equation:

$$Q = \sum_{x} Q_x \qquad\qquad (6)$$

wherein $Q_x$ is computed by combining equations (1) to (3); and the thermal runaway model of the power battery is:

$$T1 = \int_t \frac{dT}{dt}\, dt + T_0 \qquad\qquad (7)$$

wherein $T_0$ denotes the initial temperature of the battery, and $T1$ denotes the temperature of the first power battery subjected to the thermal shock with the duration.

11. The thermal runaway prediction method of claim 1, **characterized in that**, the thermal runaway standard value comprises three standard sub-values of high, medium, and low representing magnitudes of temperature values, and the temperature values corresponding to the three standard sub-values of high, medium and low decrease sequentially.

12. The thermal runaway prediction method of claim 2, **characterized in that**, a cathode active material of the second power battery is a ternary cathode active material.

13. The thermal runaway prediction method of claim 2, **characterized in that**, an anode active material of the second power battery is graphite.

14. The thermal runaway prediction method of claim 2, **characterized in that**, a conducting agent of the second power battery is acetylene black, and the binder of the second power battery is polyvinylidene fluoride.

15. The thermal runaway prediction method of claim 2, **characterized in that**, a cathode current collector of the second power battery is aluminum foil, and an anode current collector of the second power battery is copper foil.

16. The thermal runaway prediction method of claim 2, **characterized in that**, the second power battery comprises a lithium-ion power battery.

17. The thermal runaway prediction method of claim 2, **characterized in that**, the S220 comprises:

S310, disassembling the second power battery which is at the fully charged state in a glove box filled with argon gas to obtain an anode plate and a cathode plate which are at the fully charged state; and
S320, scraping the anode plate and the cathode plate off from current collectors, and grinding the anode plate and the cathode plate to obtain an anode material and a cathode material.

18. The thermal runaway prediction method of claim 17, **characterized in that**, before the S320, the method further comprises:
S311, immersing the obtained anode plate and the cathode plate respectively in dimethyl carbonate solution.

19. A thermal runaway prediction device for power battery safety, **characterized by** comprising a thermal runaway prediction apparatus (11) for the power battery safety and a computer (12), wherein the computer (12) comprises a memory (100), a processor (200), and computer programs (300) stored on the memory (200 ) and executed by the processor (200), and when the processor (200) executes the computer programs (300), the thermal runaway prediction method for the power battery safety is performed, and the method comprises:

S10, obtaining an initial temperature of the first power battery;
S20, determining a duration of a thermal shock applied to the first power battery, and calculating a temperature of the first power battery subjected to the thermal shock with the duration according to a thermal runaway model of the power battery and the initial temperature; and
S30, comparing the temperature of the first power battery subjected to the thermal shock with the duration with a thermal runaway standard value to determine whether the first power battery will undergo a thermal runaway.

20. A computer readable storage medium, having computer programs stored thereon, wherein the computer programs, when executed by a processor, cause the processor to perform steps of:

S10, obtaining an initial temperature of the first power battery;

S20, determining selecting a duration of a thermal shock applied to the first power battery, and calculating a temperature of the first power battery subjected to the thermal shock with the duration according to a thermal runaway model of the power battery and the initial temperature; and

S30, comparing the temperature of the first power battery subjected to the thermal shock with the duration with a thermal runaway standard value to determine whether the first power battery will undergo a thermal runaway.

S10

Obtain an initial temperature of the first power battery

S20

Compare the temperature of the first power battery subjected to the thermal shock with the duration with a thermal runaway standard value to determine whether the first power battery will undergo a thermal runaway

S30

Determine a duration of a thermal shock applied to the first power battery, and calculate a temperature of the first power battery subjected to the thermal shock with the duration according to a thermal runaway model of the power battery and the initial temperature

FIG.1

FIG.2

FIG.3

FIG.4

FIG.5

FIG.6

FIG.7

## INTERNATIONAL SEARCH REPORT

International application No.

**PCT/CN2018/113561**

### A. CLASSIFICATION OF SUBJECT MATTER

G01N 25/20(2006.01)i

According to International Patent Classification (IPC) or to both national classification and IPC

### B. FIELDS SEARCHED

Minimum documentation searched (classification system followed by classification symbols)

G01N25, G01R31

Documentation searched other than minimum documentation to the extent that such documents are included in the fields searched

Electronic data base consulted during the international search (name of data base and, where practicable, search terms used)

CNABS, CNKI, CNTXT: 电池, 热失控, 安全, 温度, 量热, 反应动力学, 模型, 建模, VEN, ISI Web of Knowledge: battery, batteries, thermal runaway, temperature, calorimetry, thermokinetics, model, modeling

### C. DOCUMENTS CONSIDERED TO BE RELEVANT

| Category* | Citation of document, with indication, where appropriate, of the relevant passages | Relevant to claim No. |
|---|---|---|
| PX | CN 108445039 A (TSINGHUA UNIVERSITY) 24 August 2018 (2018-08-24) paragraphs 0005-0129 | 1-20 |
| A | CN 105738813 A (STATE GRID CORPORATION OF CHINA; CHINA ELECTRIC POWER RESEARCH INSTITUTE; STATE GRID SHANDONG ELECTRIC POWER RESEARCH INSTITUTE) 06 July 2016 (2016-07-06) entire document | 1-20 |
| A | CN 106599508 A (SHANGHAI ENTRY-EXIT INSPECTION AND QUARANTINE BUREAU OF THE PEOPLE'S REPUBLIC OF CHINA) 26 April 2017 (2017-04-26) entire document | 1-20 |
| A | CN 103502829 A (IFP ENERGIES NOUVELLES) 08 January 2014 (2014-01-08) entire document | 1-20 |
| A | US 2010136391 A1 (TESLA MOTORS INC.) 03 June 2010 (2010-06-03) entire document | 1-20 |
| A | US 9812879 B2 (GRAVETT, J.R. ET AL.) 07 November 2017 (2017-11-07) entire document | 1-20 |

☑ Further documents are listed in the continuation of Box C.    ☑ See patent family annex.

| | |
|---|---|
| \*   Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **13 December 2018** | **28 January 2019** |

| Name and mailing address of the ISA/CN | Authorized officer |
|---|---|
| **State Intellectual Property Office of the P. R. China**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2018/113561**

### C. DOCUMENTS CONSIDERED TO BE RELEVANT

| Category* | Citation of document, with indication, where appropriate, of the relevant passages | Relevant to claim No. |
|---|---|---|
| Y | 许笑天 (XU, Xiaotian). "电动汽车用锂电池三维热物理模型及其应用研究 (A Three-Dimensional Thermal Model of Lithium-Ion Batteries and its Application)" 中国优秀硕士学位论文全文数据库 工程科技II辑 (Science-Engineering (B), China Master's Theses Full-Text Database), No. no. 3, 15 March 2017 (2017-03-15), pages 6, 7 and 17-31 | 1-20 |
| Y | 平平 (PING, Ping). "锂离子电池热失控与火灾危险性分析及高安全性电池体系研究 (Lithium Ion Battery Thermal Runaway and Fire Risk Analysis and the Development on the Safer Battery System)" 中国博士学位论文全文数据库 (China Doctoral Dissertations Full-Text Database), No. no. 10, 31 October 2014 (2014-10-31), pp. 23-49 | 1-20 |

Form PCT/ISA/210 (second sheet) (January 2015)

**INTERNATIONAL SEARCH REPORT**
Information on patent family members

International application No.

**PCT/CN2018/113561**

| Patent document cited in search report | | | Publication date (day/month/year) | Patent family member(s) | | | Publication date (day/month/year) |
|---|---|---|---|---|---|---|---|
| CN | 108445039 | A | 24 August 2018 | None | | | |
| CN | 105738813 | A | 06 July 2016 | None | | | |
| CN | 106599508 | A | 26 April 2017 | None | | | |
| CN | 103502829 | A | 08 January 2014 | US | 2014067297 | A1 | 06 March 2014 |
| | | | | CN | 103502829 | B | 09 March 2016 |
| | | | | FR | 2974922 | B1 | 26 April 2013 |
| | | | | JP | 2014522548 | A | 04 September 2014 |
| | | | | WO | 2012150384 | A1 | 08 November 2012 |
| | | | | EP | 2705380 | A1 | 12 March 2014 |
| | | | | FR | 2974922 | A1 | 09 November 2012 |
| US | 2010136391 | A1 | 03 June 2010 | JP | 5119302 | B2 | 16 January 2013 |
| | | | | JP | 2011060755 | A | 24 March 2011 |
| | | | | EP | 2302727 | B1 | 12 November 2014 |
| | | | | US | 9093726 | B2 | 28 July 2015 |
| | | | | EP | 2302727 | A1 | 30 March 2011 |
| US | 9812879 | B2 | 07 November 2017 | US | 2017025868 | A1 | 26 January 2017 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201810122868